(19) Europäisches Patentamt
European Patent Office
Office européen des brevets

(11) Numéro de publication: **0 228 946 B1**

(12) **FASCICULE DE BREVET EUROPEEN**

(45) Date de publication de fascicule du brevet: **30.09.92**

(51) Int. Cl.⁵: **G01R 31/26**

(21) Numéro de dépôt: **86402727.1**

(22) Date de dépôt: **09.12.86**

(54) **Procédé de test des photodiodes infrarouge d'une plaquette de détection.**

(30) Priorité: **10.12.85 FR 8518238**

(43) Date de publication de la demande:
**15.07.87 Bulletin 87/29**

(45) Mention de la délivrance du brevet:
**30.09.92 Bulletin 92/40**

(84) Etats contractants désignés:
**BE DE GB NL SE**

(56) Documents cités:

PATENTS ABSTRACTS OF JAPAN, vol. 6, no. 66 (P-112)[944], 27 avril 1982; & JP-A-57 7571 (MITSUBISHI DENKI K.K.) 14-01-1982

IEEE TRANSACTIONS ON ELECTRON DEVICES, vol. ED-27, no. 1, janvier 1980, pages 146-150, IEEE, New York, US; HIROSHI TAKIGAWA et al.: "Hybrid IRCCD imaging array"

NASA TECH BRIEF - NTN83-0336BK, NASA's Jet Propulsion Laboratory, Pasadena, California, US; L. MILLER: "Electronic load tests high-voltage solar arrays"

(73) Titulaire: **SAT Société Anonyme de Télécommunications**
**41, rue Cantagrel**
**F-75631 Paris Cedex 13(FR)**

(72) Inventeur: **Sirieix, Michel Benoît**
**11 parc de Diane**
**F-78350 Jouy en Josas(FR)**
Inventeur: **Pruvot, Henri Guy Gaston**
**86 avenue Emile Zola**
**F-75015 Paris(FR)**
Inventeur: **Virdis, Albin**
**7 rue de Viry**
**F-91600 Savigny sur Orge(FR)**

(74) Mandataire: **Bloch, Gérard et al**
**2, square de l'Avenue du Bois**
**F-75116 Paris(FR)**

## Description

La présente invention concerne un procédé de test d'une pluralité de photodiodes infrarouge d'une plaquette de détection, après hybridation sur une plaquette de traitement des courants de sortie de ces diodes, cette plaquette comprenant une pluralité de transistors d'entrée à effet de champ, en parallèle, associés aux photodiodes de détection, respectivement, et des dispositifs intégrateurs.

Si on considère, par exemple, la plaquette de détection d'une caméra thermique pour l'analyse de paysages en temps réel, cette plaquette contient une mosaïque de plusieurs centaines, voir d'un millier, de photodiodes infrarouge. Cette plaquette de détection est superposée sur et interconnectée à une plaquette de traitement, généralement en silicium semi-conducteur dans lequel sont intégrés des circuits de traitement à transfert de charges, comprenant des circuits d'entrée à injection directe comprenant une pluralité de transistors d'entrée à effet de champ, associés respectivement à la pluralité des photodiodes de détection, par connexions par exemple du type "poutre" (beam-lead). La superposition et l'interconnexion des deux plaquettes constituent ce qu'on appelle l'hybridation.

La plaquette de traitement ayant de son côté été testée, c'est-à-dire son bon fonctionnement vérifié, il convient de tester à son tour la plaquette de détection. Après un contrôle préliminaire, pour s'assurer que tous les plots du circuit de traitement, sont utilisables par exemple en mesurant les tension d'avalanche de diodes de protection de ces plots, l'hybride étant monté en cryostat, il convient en fait de s'assurer du fonctionnement correct de l'association détecteurs-silicium.

Une fois les photodiodes "hybridées" et encapsulées, il est quasiment impossible d'accéder à chacune d'elles avec un dispositif de test du type à pointes. La présente invention vise donc à proposer un procédé qui s'affranchit de cette impossibilité.

A cet effet, la présente invention concerne un procédé de test d'une plaquette de détection hybridée sur une plaquette de traitement du type mentionné ci-dessus, procédé dans lequel les informations de sortie des circuits de traitement sont multiplexées et on met sous tension les grilles de polarisation des transistors d'entrée de la plaquette de traitement, on fait varier la tension de ces grilles en mesurant, après multiplexage, pour chaque couple photodiode-transistor d'entrée et pour chaque valeur de la tension grille, la valeur de l'information de sortie du circuit correspondant de la plaquette de traitement, et on trace les courbes, caractéristiques de ces informations de sortie en fonction des tensions grille, qu'on peut, grâce à un temps d'intégration réduit par rapport à la valeur nominale du temps d'intégration imposé par les conditions de fonctionnement optimal du système utilisant une plaquette de détection associée à une plaquette de traitement, assimiler aux courbes caractéristiques des photodiodes, et on extrait les paramètres caractéristiques de chaque photodiode et de chaque transistor d'entrée, avant de ne conserver le composant hybride que si toutes les courbes sont satisfaisantes.

Si une seule des courbes obtenues n'est pas satisfaisante, c'est-à-dire si la zone d'avalanche d'une photodiode s'étend sur pratiquement toute la caractéristique, si la diode n'est pas connectée au transistor intégrateur (défaut d'interconnexion diode en circuit ouvert) ou si la résistance shunt de la diode est trop faible ou si la tension de seuil du transistor d'entrée se trouve en dehors de la variance admissible alors l'ensemble considéré de la plaquette de détection et de la plaquette de traitement hybridée est rejetée.

Le procédé de test de l'invention permet donc de déterminer dans un lot d'hybrides ceux qui sont fonctionnels et parmi ceux qui sont fonctionnels, de déterminer leurs qualités respectives.

Certes, le document IEEE Transactions on Electron Devices, vol.ED-27, No.1, janvier 1980, pp 146-150, enseigne par ailleurs une pluralité de photodiodes infrarouge connectées à une unité de traitement des courants de sortie de ces diodes et comprenant une pluralité de transistors à effet de champ et des dispositifs intégrateurs.

Le document Patent Abstracts of Japan, vol.6, No.66 (P-112), [944] 27, avril 1982 et JP-A-57 7571, enseigne par ailleurs de déterminer la courbe caractéristique tension-courant d'une batterie solaire en faisant varier la tension entre la source et la grille d'un transistor SIT, monté en série avec la batterie et un ampèremètre, et en mesurant le courant de charge et la tension entre la source et le drain du transistor.

Mais l'originalité de l'invention de la présente demande est liée au mérite de la demanderesse d'avoir constaté que la courbe courant de sortie-tension grille était, pour une bonne photodiode, quasiment identique à la courbe caractéristique de la photodiode et d'avoir proposé une méthode permettant de décrire l'intégralité de cette courbe sans saturer le dispositif intégrateur d'entrée, et qu'on pouvait directement extraire de cette courbe les paramètres essentiels de la diode et du transistor d'entrée, ce, sans avoir à reconstituer séparément les courbes courant-tension de la diode et du transistor d'entrée respectivement.

La démonstration va maintenant en être donnée.

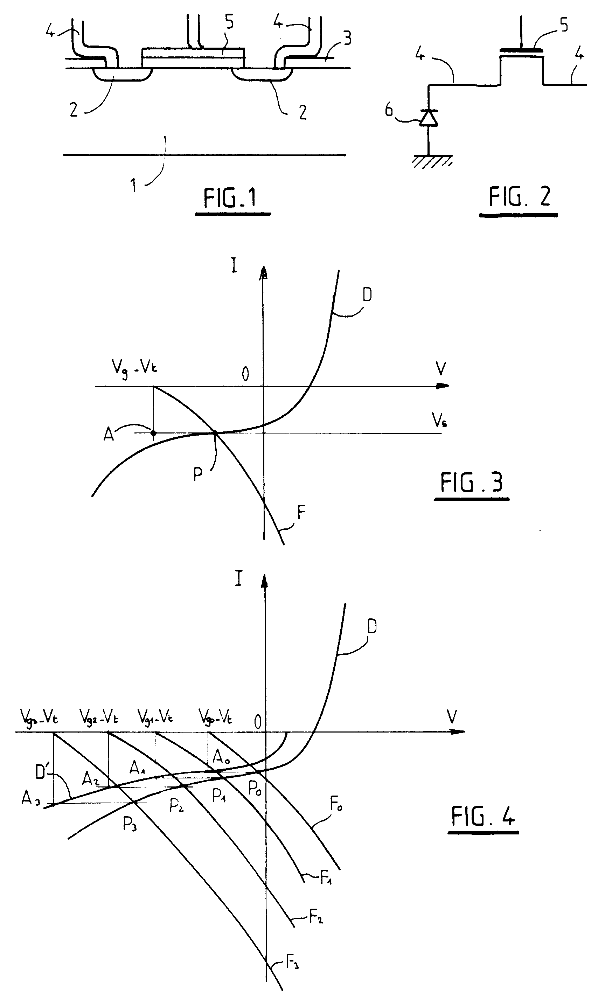

Rappelons brièvement d'abord ce qu'est un transistor à effet de champ FET (field effect transistor) à structure MOS (metal oxyd semi conductor), représenté sur la figure 1 et, par son schéma électrique, sur la figure 2.

Un substrat 1, généralement en silicium semi-conducteur, d'un type de conductivité, comporte deux zones 2 de dopage, de l'autre type de conductivité, diffusées à partir de deux ouvertures pratiquées dans une couche d'oxyde 3. Deux bornes de contact 4 connectées aux deux zones de dopage 2 constituent le drain et la source. Une couche métallique 5, sur la couche d'oxyde entre les deux ouvertures de dopage, constituant la grille de polarisation, et connectée à une troisième borne de contact, assure la polarisation du transistor. Quand la grille 5 est sous tension, il se crée sous celle-ci une charge d'espace qui comble en porteurs minoritaires l'espace s'étendant entre les deux zones de dopage 2 et qui connecte la source et le drain 4,4.

Un transistor à effet de champ ne devient passant qu'à partir d'une différence entre la tension grille $V_g$ et la tension source $V_S$ égale à une tension de seuil $V_t$, qui est une constante du transistor. Pour une valeur $V_g$ donnée, l'abscisse à l'origine de la courbe F représentative du courant I du transistor en fonction de la tension source $V_S$ est donc égale à $V_g - V_t$. Le point de fonctionnement P $(I,V_S)$ d'un étage d'entrée constitué par un transistor à effet de champ couplé à une photodiode fonctionnant en injection directe et en inverse se trouve à l'intersection de la caractéristique F du transistor et de la caractéristique D courant I - tension V de la diode (figure 3).

La connaissance de $V_g$, d'une part, et la mesure de I, d'autre part, permet donc d'appréhender le point A, d'ordonnée I et d'abscisse $V_g-V_t$, c'est-à-dire d'abscisse $V_g$ à la constante $V_t$ près.

Si on fait varier $V_g$, la courbe F se déplace, avec son abscisse à l'origine, et le point P de fonctionnement se déplace le long de la courbe D. Le point A décrit une courbe D' et c'est cette courbe D' qui, conformément à l'invention, est assimilée à la courbe D.

On a représenté sur la figure 4 cette courbe D', lieu des points $A_0$, $A_1$, $A_2$, $A_3$, ... associés aux courbes $F_0$, $F_1$, $F_2$, $F_3$, ... aux points $P_0$, $P_1$, $P_2$, $P_3$ ... et aux abscisses à l'origine, des courbes F, $V_{g0}-V_t$, $V_{g1}-V_t$, $V_{g2}-V_t$, $V_{g3}-V_t$, ... On notera que la courbe D', qui est une courbe mesurée, ne s'étend pas au-delà des courants de valeurs négatives.

Pour un transistor à effet de champ, le courant I est donné par la relation

$$I = -K (V_g - V_S - V_t)^2, \quad (1)$$

K étant une constante.

De l'équation (1) on tire

$$V_S = V_g - V_t - \sqrt{\frac{I}{K}} \quad (2)$$

Si on dérive par rapport à $V_g$ les deux membres de l'équation (2), $V_t$ étant une constante, on obtient

$$\delta V_S = \delta V_g + \frac{\delta I}{2\sqrt{KI}} \quad (3)$$

De l'équation (3) on tire, après division par $\delta I$,

$$\frac{\delta V_S}{\delta I} = \frac{\delta V_g}{\delta I} + \frac{1}{2\sqrt{KI}} \quad (4)$$

$$\frac{\delta V_S}{\delta I}$$

est l'impédance Z de la photodiode, soit la pente de la courbe caractéristique de la photodiode.

$$\frac{\delta V_g}{\delta I}$$

est la pente de la courbe D'.

$$\frac{1}{2\sqrt{KI}}$$

est l'impédance d'entrée du transistor.

Comme l'impédance de la diode, au point de fonctionnement, est beaucoup plus grande que celle du transistor lorsque la diode est bonne, c'est-à-dire quand elle présente une portion de courbe I (V) presque horizontale, on peut donc, en première approximation, négliger le terme

$$\frac{1}{2\sqrt{KI}}$$

pour écrire

$$\frac{\delta V_S}{\delta I} = \frac{\delta V_g}{\delta I} \qquad (5)$$

La relation (5) démontre donc le bien-fondé de l'assimilation de la courbe D de la diode I (V), ou I (V_S)-, à la courbe D' lieu du point A mesuré I (V_g), dont les pentes sont les mêmes.

Toutes les grilles des transistors d'entrée sont portées à la même tension, et les informations de sortie des circuits de traitement sont multiplexés.

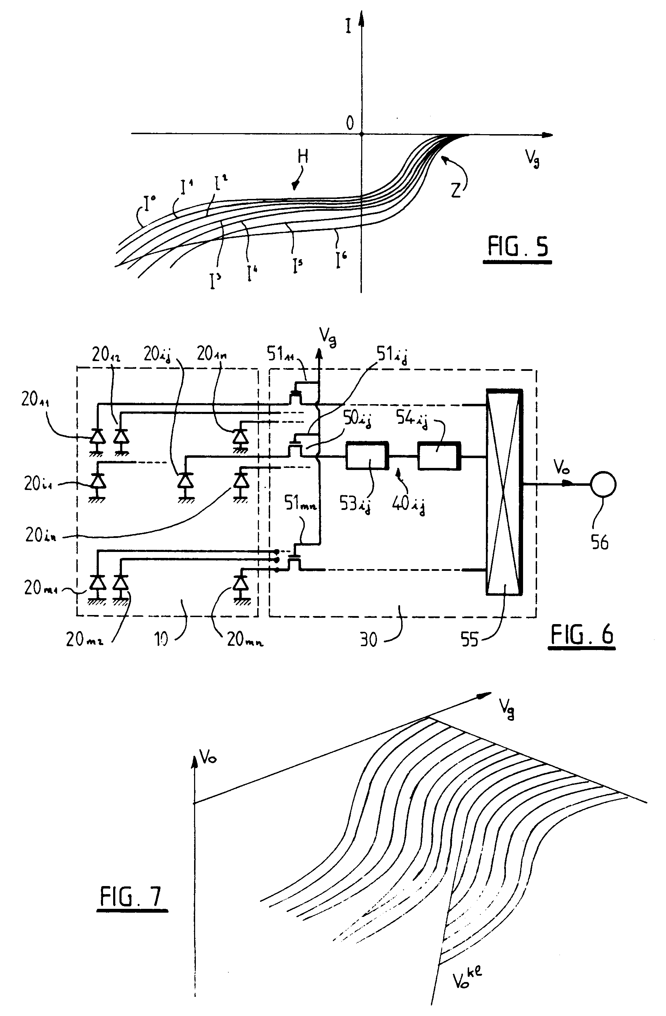

Ainsi, si on incrémente la tension grille $V_g$ des transistors et que l'on mesure, pour toutes les valeurs de $V_g$, les valeurs des courants de sortie I relatifs à toutes les photodiodes, on obtient un réseau de caractéristiques $I^0(V_g)$, $I^1(V_g)$, $I^2(V_g)$,... pour l'ensemble des photodiodes de la plaquette de détection (figure 5).

En référence à la figure 5, on remarquera que les courbes I ($V_g$) du réseau sont tangentes à l'axe des abscisses $V_g$, au lieu de le couper. Cela tient au fait que, dans cette zone Z des courbes, proche de cet axe, négliger le terme

$$\frac{1}{2\sqrt{KI}}$$

est une approximation fausse. L'essentiel reste toutefois la quasi-horizontalité des courbes dans la zone H.

D'autre part, la dispersion des abscisses à l'origine correspondant aux différentes courbes est identique à la dispersion des tensions de seuil des transistors d'entrée. On a ainsi accès à un paramètre essentiel du circuit de traitement.

Dans la pratique, on mesurera, non pas les courants de sortie, mais, et après intégration et conversion, les tensions de sortie $V_0$ des circuits de traitement, qui sont proportionnelles aux courants de sortie, selon la fonction de transfert des circuits de traitement

$$V_0 = \frac{T}{C} I,$$

T étant le temps d'intégration pour la transformation du courant en quantité de charges,
C étant la capacité ce la diffusion de sortie du circuit de traitement pour la conversion en potentiel de la quantité de charges.

En fait, au-delà d'une certaine valeur de $V_g$ le dispositif intégrateur d'entrée est saturé, c'est-à-dire D′ n'est plus assimilable à D. C'est notamment le cas de détecteurs de faible impédance ou qui présentent une tension d'avalanche peu élevée. Afin que l'intégralité de D′ soit assimilable à l'intégralité de D, il faut réduire le temps d'intégration effectif par rapport à la valeur nominale de celui-ci imposé par les conditions de fonctionnement optimal du système utilisant l'association [Détecteur-Silicium] (par exemple le système d'une caméra thermique à balayage).

L'invention sera totalement comprise à l'aide de la description suivante d'un hybride dont la plaquette de détection est à tester selon le procédé de l'invention.

La figure 1 représente un transistor à effet de champ à structure MOS.

La figure 2 représente le schéma électrique du transistor de la figure 1.

La figure 3 représente les courbes caractéristiques d'une photodiode et d'un transistor à effet de champ couplé à la photodiode.

La figure 4 représente un réseau de courbes caractéristiques d'un transistor à effet de champ pour différentes valeurs de tension grille.

La figure 5 représente un réseau de caractéristiques courants de sortie silicium - tensions grilles de transistors d'entrée du circuit silicium associés à des photodiodes.

La figure 6 représente schématiquement une plaquette de détection et une plaquette de traitement hybridée, à tester selon le procédé de l'invention, et

La figure 7 représente un réseau de caractéristiques similaires à celles de la figure 5, mais en représentation spatiale.

La plaquette de détection 10 à tester, en l'occurence celle d'une caméra thermique pour l'analyse de paysages en temps réel, contient une mosaïque de photodiodes infrarouge $IR20_{11},20_{12},...20_{1n},20_{il},...20_{ij},...20_{in},20_{ml},20_{m2},...20_{mn}$, disposées en n lignes et m colonnes. La plaquette de détection 10 est superposée sur et interconnectée à une plaquette de traitement 30, en l'espèce sur substrat silicium semi-conducteur. Ainsi chaque photodiode $20_{ij}$ est reliée, ici par beam-lead, à un circuit à transfert de charges CCD $40_{ij}$ de la plaquette 30, son anode étant reliée à la masse.

Chaque circuit $40_{ij}$ comprend un transistor à effet de champ $50_{ij}$, ici à structure MOS, relié, par sa source, à la cathode de la diode $20_{ij}$, et, par son drain, à un intégrateur $53_{ij}$. L'intégrateur $53_{ij}$ assure la transformation du courant de la diode $20_{ij}$ en quantité de charges. L'intégrateur $53_{ij}$ est relié, par sa borne opposée à celle qui est reliée au transistor $50_{ij}$, à un convertisseur quantité de charges-tension $54_{ij}$. Le convertisseur $54_{ij}$ assure en fait une division par une valeur capacitive. La sortie du convertisseur $54_{ij}$ est reliée à une entrée d'un multiplexeur 55.

Les grilles 51 des transistors 50 sont toutes reliées à une source de tension variable $V_g$.

Le test de la plaquette de détection 10 consiste à faire varier la tension $V_g$, à mesurer, à l'aide d'un voltmètre 56 connecté à la sortie du multiplexeur 55, pour les différentes valeurs de $V_g$, les différentes valeurs des tensions $V_0$ de sortie des circuits de traitement 40, à tracer le réseau des courbes caractéristiques $V_0(V_g)$, associées aux photodiodes 20, respectivement, et à vérifier qu'elles sont satisfaisantes.

Avantageusement, le réseau de courbes $V_0(V_g)$ est tracé en représentation spatiale, ce qui permet de mieux approcher encore la qualité du composant hybride IR-CCD.

A titre d'exemple, on a représenté, sur la figure 7, un tel réseau spatial, faisant apparaître un défaut d'impédance très marqué en liaison avec la courbe $V_0^{kl}(V_g)$ de la diode $20_{kl}$, c'est-à-dire que la tension $V_0$ ou le courant I croît très vite avec la tension grille $V_g$. Au contraire, les autres éléments de détection exhibent des impédances très élevées, c'est-à-dire un "plateau" quasi-horizontal et une zone d'avalanche lointaine, et sont donc sans défaut.

Néanmoins, un tel composant hybride est à rejeter.

La représentation spatiale du réseau de courbes s'effectue facilement par des moyens informatiques, par exemple à l'aide du programme ci-dessous.

```
10        OPTION BASE 1
20        INTEGER Y(64,256),Yref(64)
30        DIM T$[40],St$[40]
40        SHORT X(256),O(64,256)
50        MAT Yref=ZER
60        MAT O=ZER
70        Copy$=""
80        DATA V sortie = f(Vpol),points de mesure), Vpol (Volts),Vs (Volts),.
,.,.,.6,1.4,0,2.
90        READ T$,St$,X$,Y$,C1$,C2$,C3$,Xi,Xf,Yi,Yf
100       Sc=3
110       V$="O"
120       Vpmax=1.5
130       G=2
140       O=150
150       Choix$="Mtd"
160       Xi=.5
170       Xf=1.5
180       M=Mo=64
190 Acq:N=INT((Xf-Xi)/Vpmax*256)
200       Sc=1
210       WRITE IO Sc,5;0
220       WRITE BIN Sc;-(1+0+256*G)
230       REDIM X(N),Y(Mo,N),O(M,N)
240       MAT Y=ZER
250       FOR I=1 TO N
260          Sc=3
270          WRITE IO Sc,5;2
280          V=INT(255*(Xi+(Xf-Xi)*(I-1)/(N-1))/Vpmax)
290          X(I)=Vpmax*V*(1/255)
300          PRINT X(I)
310          WRITE BIN Sc;-(1+V+30*2^8)
320          IF I=1 THEN WAIT 1000
330          WAIT 50
340          Sc=1
350          FOR J=1 TO Mo
360             WRITE IO Sc,5;1
370             WRITE IO Sc,5;0
380 S:          READ IO Sc,5;A
390             IF A=34 THEN S
400             Uo=READBIN(Sc)
410             Y(J,I)=-1-Uo+Y(J,I)
420          NEXT J
430       NEXT I
440       Sc=3
450       WRITE IO Sc,5;2
460       WRITE BIN Sc;-256
470       WRITE IO Sc,5;3
```

```
480 Zero:Noo=5
490     IF N<20 THEN Noo=2
500     FOR J=1 TO Mo
510       Yref(J)=0
520       FOR I=1 TO Noo
530         Yref(J)=Yref(J)+Y(J,I)
540       NEXT I
550       Yref(J)=Yref(J)/Noo
560       FOR I=1 TO N
570         Y(J,I)=Y(J,I)-Yref(J)
580       NEXT I
590     NEXT J
600 Id: MAT O=Y
610     Koe=1.613
620     Gain=Koe*10/(1024*G)
630     MAT O=O*(Gain)
640 Plot:PLOTTER IS "GRAPHICS"
650     GRAPHICS
660     St$="("&VAL$(N)&" "&St$
670     LOCATE 0,141.43,0,100
680     MOVE 65,94
690     LABEL T$
700     MOVE 65,89
710     LABEL St$
720     MOVE 65,3
730     LABEL X$
740     MOVE 3,89
750     LABEL Y$
760     LOCATE 15,120,10,85
770     SCALE Xi,Xf,Yi,Yf
780     LAXES (Xf-Xi)/20,(Yf-Yi)/20,Xi,Yi,-5,5
790     FRAME
800     FOR J=1 TO M
810       Mm=J MOD 5+4
820       MOVE X(1),O(J,1)
830       FOR I=1 TO N
840         DRAW X(I),O(J,I)
850       NEXT I
860     NEXT J
870     END
```

## Revendications

1. Procédé de test d'une pluralité de photodiodes infrarouge (20) d'une plaquette (10) de détection, après hybridation sur une plaquette (30) de traitement des courants de sortie de ces diodes, cette plaquette (30), comprenant une pluralité de transistors d'entrée à effet de champ (50), en parallèle, associés aux photodiodes de détection (20), respectivement, et des dispositifs intégrateurs, procédé dans lequel les informations de sortie des circuits de traitement (40) sont multiplexées et on met sous tension les grilles de polarisation (51) des transistors d'entrée (50) de la plaquette (30) de traitement, on fait varier la tension de ces grilles en mesurant (56), après multiplexage, pour chaque couple photodiode-transistor d'entrée et pour chaque valeur de la tension grille, la valeur de l'information de sortie du circuit correspondant (40) de la plaquette de traitement, et on trace les courbes, caractéristiques de ces informations de sortie en fonction des tensions grille, qu'on peut, grâce à un temps d'intégration réduit par rapport à la valeur nominale du temps d'intégration imposé par les conditions de fonctionnement optimal du système utilisant une plaquette (10) de détection associée à une plaquette (30) de traitement, assimiler aux courbes caractéristiques des photodiodes (20), et on extrait les paramètres caractéristiques de chaque photodiode et de chaque transistor d'entrée, avant de ne conserver le composant hybride que si toutes les courbes sont satisfaisantes.

2. Procédé de test selon la revendication 1, dans lequel on porte toutes les grilles (51) des transistors d'entrée (50) à la même tension.

3. Procédé de test selon l'une des revendications 1 et 2, dans lequel on intègre (53) les courants de sortie des transistors d'entrée (50) de la plaquette de traitement (30) pour transformer les courants en quantités de charges et, avant multiplexage (55), on convertit (54) les quantités de charges en potentiels.

4. Procédé de test selon l'une des revendications 1 à 3, dans lequel lesdites courbes caractéristiques sont tracées en représentation spatiale.

## Claims

1. Process for testing a plurality of infrared photodiodes (20) of a detection plate (10), after hybridisation on a plate (30) for the treatment of the output currents of these diodes, this plate (30), comprising a plurality of input field effect transistors (50), in parallel, associated with the detection photodiodes (20), respectively, and integrator devices, a process in which the output informations of the treatment circuits (40) are multiplexed and the polarisation grids (51) of the input transistors (50) of the treatment plate (30) is supplied with voltage, the voltage of these grids is varied by measuring (56), after multiplexing, for each photodiode/input transistor pair and for each value of the grid voltage, the value of the output information of the corresponding circuit (40) of the treatment plate and one draws the curves characteristic of these output information as a function of the grid voltages, which one can, by virtue of a reduced integration time with respect to the nominal value of the integration time imposed by the optimum operating conditions of the system using a detection plate associated with a treatment plate, consider as the characteristic curves of the photodiodes (20) and one extracts the parameters characteristic of each photodiode and of each input transistor, before retaining the hybrid component solely if all the curves are satisfactory.

2. Testing process according to Claim 1, in which the same voltage is supplied to all the grids (51) of the input transistors (50).

3. Testing process according to one of Claims 1 and 2, in which the output currents of the input transistors (50) of the treatment plate (30) are integrated (53) in order to transform the currents into charge quantities and, before multiplexing (55), the charge quantities are converted (54) into potentials.

4. Testing process according to one of Claims 1 to 3, in which said characteristic curves are drawn in spatial representation.

## Patentansprüche

1. Verfahren zur Prüfung einer Vielheit von auf einer Detektorplakette (10) angeordneten Infrarotphotodioden nach Hybridisierung auf einer Plakette (30) zur Verarbeitung der Ausgangsströme dieser Dioden, wobei diese Plakette (30) eine Vielheit von parallel angeordneten, den Detektordioden (20) zugeordneten Eingangs-Feldeffekttransistoren (50) und Integriervorrichtungen umfaßt, Verfahren bei welchem die Ausgangsinformationen der Verarbeitungskreise (40) multigeplext werden und die Gitter (51) der Eingangstransistoren (50) der Verarbeitungsplakette (30) unter Spannung gesetzt werden, bei welchem die Spannung dieser Gitter geändert wird, indem, nach Multiplexing, für jedes Paar Photodiode/Eingangstransistor und für jeden Gitterspannungswert, der Wert der Ausgangsinformation des entsprechenden Kreises (40) der Verarbeitungsplakette gemessen wird (56) und die Kennlinien dieser Ausgangsinformationen in Abhängigkeit von den Gitterspannungen gezeichnet werden, Kennlinsen, die, dank einer Integrierzeit, welche in Bezug auf den Nennwert der durch die optimalen Betriebsbedingungen des eine Detektorplakette und eine dieser Verarbeitungsplakette verwendenden Systems auferlegten Integrierzeit verkürzt ist, an die Kennlinien der Photodioden (20) angeglichen werden können, und bei welchem, nur wenn alle Kurven zufriedenstellend sind, die charakteristischen Parameter jeder Photodiode und jedes Eingangstransistors ausgeblendet werden, bevor die Hybridkomponente behalten wird.

2. Prüfungsverfahren gemäß Anspruch 1, bei welchem alle Gitter (51) der Eingangstransistoren (50) auf gleiche Spannung gebracht werden.

3. Prüfungsverfahren gemäß einem der Ansprüche 1 oder 2, bei welchem die Ausgangsströme der Eingangstransistoren (50) der Verarbeitungsplakette (30) integriert werden, um die Ströme in Ladungsmengen umzuwandeln und bei welchem vor dem Multiplexing (55) die Ladungsmengen in Potentiale umgewandelt werden (54).

4. Prüfungsverfahren gemäß einem der Ansprüche 1 bis 3, bei welchem die besagten Kennlinien in räumlicher Darstellung gezeichnet werden.

FIG.1

FIG. 2

FIG . 3

FIG . 4

FIG. 5

FIG. 6

FIG. 7